# EUROPEAN PATENT APPLICATION

(11) **EP 0 969 494 A1**
(43) Date of publication of application: **05.01.2000**
(21) Application number: 99112835.6
(22) Date of filing: 02.07.1999
(51) Int. Cl.: H01J 37/02

(54) **Apparatus and method for examining specimen with a charged particle beam**

(30) Priority: 03.07.1998 EP 98112389; 09.11.1998 DE 19851622
(71) Applicant: ICT Integrated Circuit Testing Gesellschaft für Halbleiterprüftechnik mbH, 85551 Heimstetten (DE)
(72) Inventor: Feuerbaum, Hans-Peter Dr., 81739 Müunchen (DE); Winkler, Dieter Dr., 81739 München (DE)
(74) Representative: Zimmermann, Gerd Heinrich

(57) **Abstract**

An apparatus for examining a specimen with a beam of charged particles. The apparatus comprises a particle source for providing a beam of charged particles and an optical device for directing said beam of charged particles onto said specimen to be examined. Furthermore, a gas supply provides inert gas to the area of incidence of said beam of charged particles onto said specimen. The specimen can be loaded into a vacuum chamber.

## Description

### FIELD OF THE INVENTION

This invention relates to a charged particle beam device for the examination of specimen. In particular, this invention relates to the examination of specimen which have the tendency of getting charged while being radiated with a charged particle beam.

### BACKGROUND OF THE INVENTION

Negatively or positively charged particles coming from a particle source can be accelerated by a potential of U volts. The direction of travel of such a moving particle is altered either by applying a magnetic or an electric field e.g. a charged particle moving in a magnetic field experiences a force tending to change its direction of motion except when it is travelling parallel to the magnetic lines of force. Suitably shaped magnetic and electric fields can be used to cause charged particles diverging from a source to converge into a beam, guide the beam along a predetermined path and allowing it to impinge on the surface of a substrate or a specimen.

The charged particles interact with the atoms of the specimen and cause a number of different effects in the specimen or on its surface. Without limiting the scope of the present invention, the following explanations will primarily concentrate on the use of electrons as charged particles. The impinging electrons, thereafter called primary electrons (PE), are deflected by collisions with specimen atoms. These collisions may be elastic when the electron is deflected (even up to 180 degrees ), but no energy interchange occurs. They may also be inelastic when the primary electron interacts with the atom and supplies energy for a further process to occur. Such a process could result in the emission of an electron, called secondary electron (SE) and/or electromagnetic radiation. Thereby, the primary electron generally experiences only a small deviation of track. After the collision or collisions, the primary electron may re-emerge as backscattered electron (BSE) or as transmitted electron, or may lose all its energy and come to rest in the specimen. There, the primary electron contributes to the specimen's heating or to the specimen's absorbed charge.

The above indicated physical effects can provide much analytical information about the specimen. In the following the creation of secondary electrons and their informational content of the specimen will be considered in greater detail. An inelastic collision of an incident primary electron having a kinetic energy of e.g. 1keV, can result in electrons being detached from the specimen atoms. This leaves behind an ionized atom with a positive charge. The dislocated electrons have a low kinetic energy, typically less than 50 eV, and are easily captured by nearby atoms. Some electrons which are created closer to the surface can be emitted from the specimen and can be collected with specific detectors. Consequently, only a small portion of the secondary electrons formed are available for collection. Since the emitted SE originate from a small region very close to the surface of the specimen, they carry corresponding surface information.

In particular, a surface of the specimen which is tilted relative to the incident beam reacts differently than a surface perpendicular to the incident beam. Compared to a flat surface, the electrons having entered a tilted surface of the specimen propagate a longer distance close to the specimen's surface. This results in a greater proportion of secondary electrons that are to escape and the electron emission from the surface will increase. The intensity of the secondary electron emission is therefore an indicator of the surface slope and topography. Therefore, the intensity signals collected by secondary electron detectors can be used for high-resolution surface imaging. Instruments visualizing these surface effects have become increasingly important for the development of e.g. microelectronic components. They are used to identify deviations from predetermined patterns or to evaluate topographical parameters such as height, width or angle of inclination of the structure under examination.

Primary electrons absorbed by the specimen contribute to its charge. This is especially true for insulators and semiconductors where it easily accumulates. The charge can result in a strong electrical field prevailing at the surface of the specimen and substantially altering the image of its surface by, for example, altering the path of PE's and SE's. In a semiconductor device, for example, electric insulators such as SiO2 are often deposited on conductors such as Al or semiconductors such as silicon. When a PE beam is directed onto the device, the surface of the insulator is charged. The resulting electric field can prevent SE created at the bottom of a contact hole from reaching the detector. Also, a single line on an integrated circuit will create a different image compared to the same line in direct vicinity to other lines. The apparent size variations caused by charging are in the order of several tens of nm, which is significant for critical dimension measurements.

In the past, a variety of methods have been tried to solve these problems. The approaches included adaptation of the acceleration voltage and the current of the electron beam. Others have altered the scanning speed of the primary electron beam or modulated the primary electron beam before impinging on the specimen. However, these methods have not been satisfactory. In some cases the intensity of the emitted secondary electrons is too low, in other cases the results obtained by comparative measurements are unreliable.

In an alternative approach Environmental Scanning Electron Microscopes (ESEM) have been used. Originally these instruments were developed for the examination of specimens which are sensitive to dehydration caused by the vacuum in the specimen chamber. The use of a low pressure environment in the chamber prevented the dehydration. As a secondary effect the presence of ions in the irradiated gas impeded charging of the specimen. These ESEM systems, however, cause widening of the beam of charged particles due to the scattering of the primary electrons. Also, the high gas concentration in the electrical fields between the detectors and the specimen can result in arcing. Therefore, the ESEM systems did not lead to satisfactory results either and cannot be used for semiconductor applications since such applications require high vacuum environment.

### SUMMARY OF THE INVENTION

The present invention intends to provide an improved apparatus and method for examining a specimen with a charged particle beam. According to one aspect of the present invention, there is provided an apparatus as specified in claim 1.

According to another aspect of the present invention, there is provided a method as specified in claim 20.

Further advantageous, features, aspects and details of the invention are evident from the dependent claims, the description and the accompanying drawings. The claims are intended to be understood as a first non-limiting approach to define the invention in general terms.

According to a further aspect of the present invention, there is provided an apparatus for examining a specimen with a beam of charged particles. The apparatus comprises a particle source for providing a beam of charged particles which propagate along an optical axis and an optical device for directing said beam of charged particles onto said specimen to be examined. Further, the apparatus comprises a gas supply for providing an inert gas to the area of incidence of said beam of charged particles onto said specimen, and a vacuum chamber for loading said specimen.

According to a preferred aspect of the present invention, the inert gas is provided in the form of a layer. This layer preferably covers the area of the specimen where the beam of charged particles is incident. In the context of this application "layer" is not understood as a geometrical object with clearly defined limits. Rather, the inert gas molecules forming the layer preferably have a higher concentration in the area of the specimen where the beam is incident. The concentration decreases along the beam with increasing distance to the specimen.

In a further preferred aspect of the present invention, a nozzle directs the stream of inert gas to the area of incidence. This could preferably be done by either varying the gas flow or by varying the pressure, or by varying both. Instead of a single nozzle two or more can be used to provide the inert gas. In such a case the nozzles are preferably arranged in a symmetrical pattern.

According to a still further aspect of the present invention, there is provided an electrode in the vicinity of the area of incidence of the charged particle beam. The electrode allows a controlled charging of the specimen. The inert gas will cause an exchange of charge between the specimen and the electrode. Advantageously, the electrode establishes a desired voltage level in a limited region of the specimen. Furthermore, it is preferred to provide means for positioning the electrode e.g. with an x-y-z manipulator. Depending on the material or the surface structure of the specimen, the electrode can be placed at a specific location over the specimen with a specific distance from it.

In a preferred embodiment according to the invention, the nozzle and the electrode are provided as an integral part. This can be achieved either by a common carrier or by attaching the electrode to the nozzle. Preferably the electrode is arranged in front of the nozzle. Both parts, the nozzle and the electrode, advantageously comprise a coupling device. This allows to exchange them with other nozzles or electrodes having different geometrical dimensions and therefore different physical properties.

It is preferred to use an electrode creating an electrostatic field with a rotational symmetry. This symmetry limits the influence on the trajectory of the incident charged particle beam and the secondary electrons. In a preferred embodiment, the electrode is a circular ring electrode with the charged particle beam being guided through its center.

Advantageously, the electrode comprises a conductive net. At least one of the net meshes is used to let the particle beam pass. Although such an arrangement will slightly distort the rotational symmetry of the resulting electrostatic field, it improves the efficiency of the electrode in controlling the charging.

According to another aspect there are provided vacuum means capable of providing a pressure gradient in the specimen chamber. Preferably the pressure gradient is established along the incident particle beam with a higher pressure at the point of incidence and a lower pressure at the aperture for permitting the particle beam enter the specimen chamber. The pressure gradient reduces the number of collisions between the particle beam and any atoms or molecules other than those in the specimen. Preferably the pressure gradient is established in such a way that the particles of the incident beam collide on the average less than once with an atom or molecule in the chamber before hitting the specimen.

According to still another aspect of the present invention, there is provided a gas tank connected to the gas supply. The gas tank can be detached and replaced with another gas tank containing different gases. In a preferred embodiment, the gas tank comprises different chambers and a switch module for feeding different gases to the specimen chamber.

According to a further aspect of the present invention, there is provided an apparatus for examining a specimen with a beam of charged particles which comprises a particle source for providing a beam of charged particles and an optical device for directing said beam of charged particles onto said specimen to be examined. Furthermore, the apparatus comprises a nozzle for directing a stream of inert gas to an area of the specimen being examined by the incident particle beam. Preferably, the apparatus also comprises a vacuum chamber in communication with vacuum means capable of providing within said vacuum chamber a pressure gradient along the beam of charged particles.

Preferred inert gases used in the context of this application are N₂, CO₂ or SF₆, or noble gases such as Ar. The gases used, however, are not limited to those mentioned above. Any other gas which is inert to reacting with the surface of the specimen can be used.

According to still another aspect of the present invention, there is provided an apparatus for inspecting a not ideally conductive sample. The apparatus comprises a particle source for providing a beam of charged particles and an optical device for directing said beam of charged particles onto said not ideally conductive sample. The apparatus further comprises means for providing a layer of inert gas over the area of incidence of said beam of charged particles onto the sample to be inspected whereby said means for providing a layer of inert gas comprise at least one nozzle preferably being connected to an inert gas tank. A reference electrode controls the voltage of the region of said sample to a preselected voltage. The reference electrode preferably comprises a circular aperture.

According to another aspect of the invention, inert gas is provided to the area of incidence in a discontinuous or pulsating manner. This allows reduction of the amount of inert gas in the specimen chamber. Inert gas is primarily guided to the area of incidence when it is needed for decharging.

According to a further aspect of the invention, the gas conduit is integrated into the objective lens or into any other mechanical parts close to the specimen. Such an arrangement allows for the use of existing set up of a microscope column and maintains the rotational symmetry around the optical axis.

According to a still further aspect of the present invention, there is provided a charged particle beam apparatus comprising a particle source and an optical device for directing a beam of charged particles onto said specimen to be examined. The apparatus further comprises a gas supply for providing a gas to the area of incidence of said beam of charged particles and a 2-way valve arranged in the gas supply whereby a first port of the 2-way valve is connected with a gas reservoir and a second port of the gas supply is connected with a vacuum reservoir. A control unit switches the 2-way valve.

The invention is also directed to methods by which the described apparatus operates. It includes method steps for carrying out every function of the apparatus. Furthermore, the invention is also directed to apparatus for carrying out the disclosed methods and including apparatus parts for performing each described method step. These method steps may be performed by way of hardware components, a computer programmed by appropriate software, by any combination of the two or in any other manner.

### BRIEF DESCRIPTION OF THE DRAWINGS

Some of the above indicated and other more detailed aspects of the invention will be described in the following description and partially illustrated with reference to the figures. Therein:
Fig. 1 is a schematic vertical cross section of an objective lens for a charged particle beam device comprising a gas conduit with a symmetrical electrode.
Fig. 2 is a schematic vertical cross section of a second objective lens for a charged particle beam comprising a tube shaped gas conduit.
Fig. 3 shows a simplified cross section of the optical column of a scanning electron microscope with a gas supply attached to the specimen chamber.
Fig. 4a shows a top view of two gas nozzles arranged symmetrically around the area of incidence of the primary electron beam.
Fig. 4b shows a top view of four gas nozzles arranged symmetrically around the area of incidence of the primary electron beam.
Fig. 4c shows a top view of three gas nozzles arranged symmetrically around the area of incidence of the primary electron beam.
Fig. 5a shows a top view of a gas nozzle with a reference electrode at the nozzle tip.
Fig. 5b shows a top view of a gas nozzle with a reference electrode arranged directly behind the nozzle tip.
Fig. 5c shows a top view of two gas nozzles with a reference electrode at their nozzle tips.
Fig. 5d shows a top view of a gas nozzle with a reference electrode at the nozzle tip, the reference electrode comprising a conductive net.
Fig. 6 shows a possible time correlation between the scan movement of the charged particle beam and the gas flow.
Fig. 7 shows a possible time correlation between a pulsed charged particle beam and the gas flow.
Fig.8 shows an objective lens with an integrated gas conduit whereby the gas conduit is integrated into a pole piece of the magnetic lens.
Fig.9 shows an objective lens with an integrated gas conduit whereby the gas conduct is integrated into an electrode of the electrostatic lens.
Fig.9a shows an objective lens with a reference electrode whereby the gas conduit is integrated into the reference electrode arranged below the objective lens.
Fig. 10 shows a gas conduit directed to the specimen with a valve arranged between the gas reservoir and the specimen chamber.
Fig. 11 shows a gas conduit directed to the specimen with a micro valve arranged at the end of the gas conduit.
Fig. 12 shows a gas conduit directed to the specimen with a 2 way valve arranged in the gas conduit.

### DESCRIPTION OF THE PREFERRED EMBODIMENTS

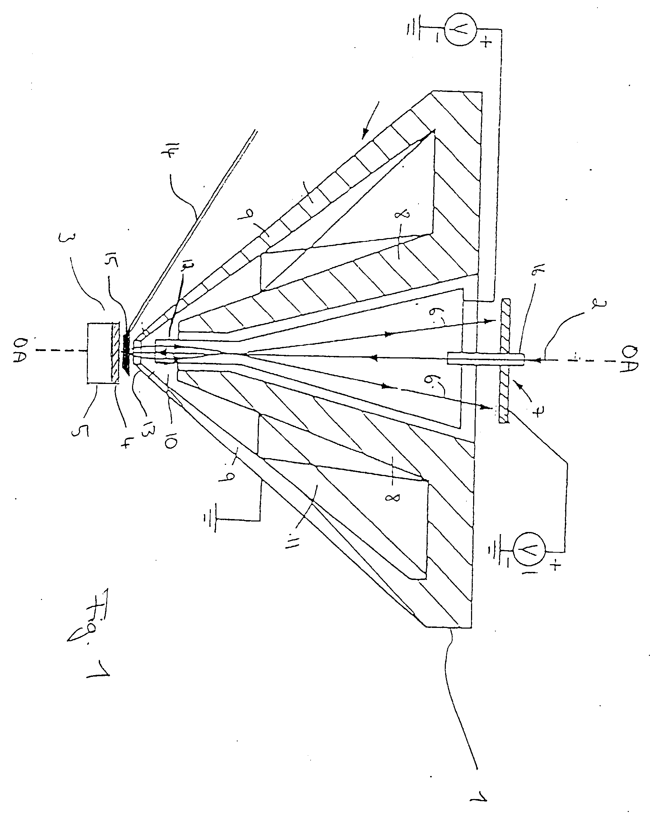

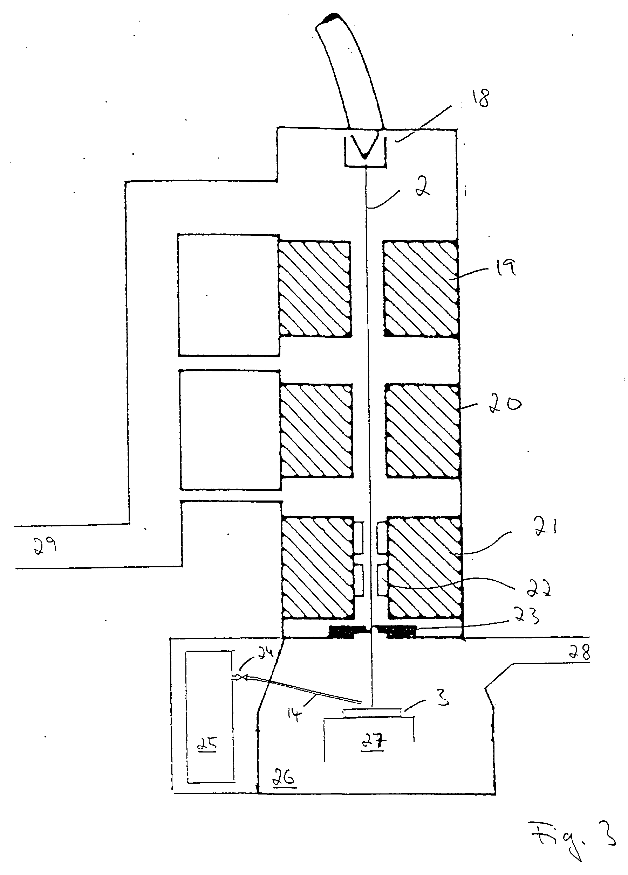

An exemplary embodiment of an objective lens unit 1 used in an apparatus for examining a specimen is shown in Fig. 1. This lens is preferably used as a component in the optical column of a scanning electron microscope. A primary electron beam 2 generated by an electron source (shown in Fig. 3) propagates along an optical axis OA and is focused onto a specimen 3. It is not required that the primary electron beam always propagates along the optical axis. On its way from the source to the specimen the particle beam can be deflected from the optical axis OA or its vicinity and, at a later stage, reflected back to the optical axis. In the shown embodiment the specimen 3 is a microelectronic component with an insulator layer 4 on substrate layer 5. For examining the specimen, a particular region of the specimen is scanned with the primary electron beam. The scanning or deflection of the beam is done by the scanning coil system which is driven by a scanning generator (both not shown in Fig. 1). The interactions of the beam with the specimen result e.g. in secondary electrons. In the area of incidence, due to the insulating surface 4 of the specimen, the primary electron beam will cause localized charging. The secondary electrons can be measured with an appropriate detector 7. In the illustrated example the detector is arranged immediately above the lens body symmetrically relative to the optical axis OA. The detector 7 is preferably an annular electron sensitive part that includes a hollow cylinder 16 fitted into a central bore therein. The hollow cylinder 16, which can be charged with a somewhat lower positive potential compared to the upper electrode 12 of the electrostatic lens, extends into the upper body of the lens body.

The shown conical magnetic lens having an upper pole piece 8 and a lower pole piece 9 is fed by an excitation coil 11. The magnetic flux of the magnetic lens is concentrated in the area of the pole piece gap 10 between the upper and lower pole pieces 8, 9. Here, the magnetic field reaches its maximum strength and is nearly rotationally symmetrical about the optical axis OA.

The imaging properties of the objective lens unit 1 are also determined by the electrostatic lens. In the embodiment shown, an upper electrode 12 and a lower electrode 13 establish a nearly rotationally symmetrical electric lens field with its principal plane located inbetween the principal plane of the conical magnetic lens and the specimen 3. In the illustrated exemplary embodiment the upper electrode 12 is preferably in the form of a truncated cone tapering in the direction of the specimen; its end part is a cylindrical tube projecting into the region of the pole piece gap 10. The positive potential of this electrode is, for example, 5 to 10 kV. The lower electrode 13 which has a conical shape is , for example, grounded. The resulting electric field is a retarding field decelerating the high speed electrons coming through the upper electrode 12.

Between the specimen 3 and the lower electrode 13 a reference electrode 15 is arranged. In the shown embodiment the electrode has a rotationally symmetrical shape. The reference electrode is arranged at the end of gas conduit 14 which supplies the inert gas to a nozzle integrated into the reference electrode. On one hand, the reference electrode 15 can be used to establish a predetermined voltage in the part of the specimens surface which is located in the direct vicinity of the reference electrode. On the other hand, depending on the voltage applied to it, the reference electrode also assists in sucking secondary electrons from the wafer's surface. Deviations of the electrostatic field caused by the presence of the nozzle are, for example, minimized by arranging a symmetrical electrode at the nozzles tip portion. In a preferred embodiment the nozzle aperture is shaped as an annular opening along the circumference of the reference electrode. Alternatively, such an annular opening of the nozzle aperture can also be used without combining it with a reference electrode. In this case, the circular shaped nozzle attachment 15 acts solely as a circular gas outlet.

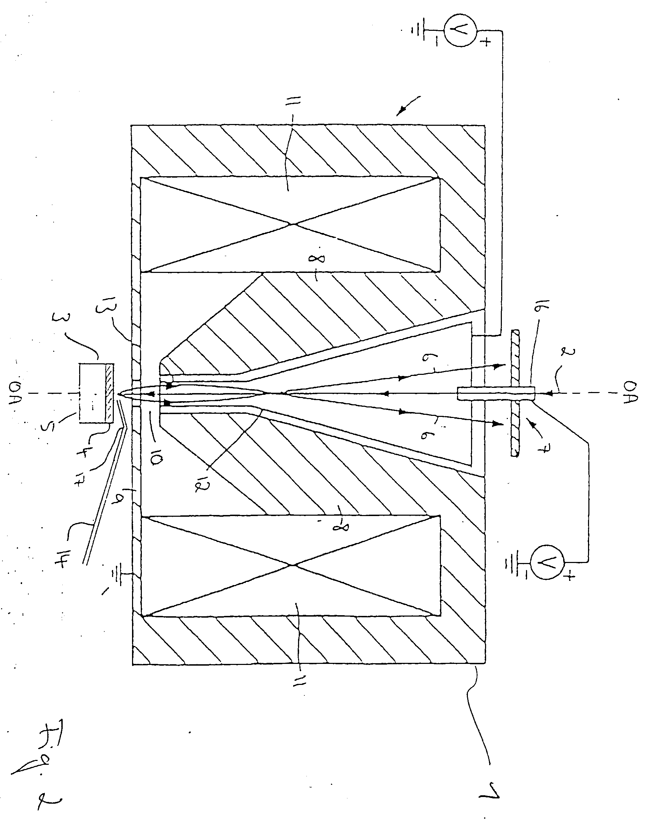

Fig. 2 shows another objective lens 1 for focusing a beam of primary electrons 2 on the specimen. The lens is essentially composed of a magnetic lens and an electrostatic lens generating fields which are essentially rotationally symmetrical around the optical axis OA of the objective lens. The detector 7 is arranged immediately above the lens body and documents secondary electrons 6 triggered at the specimen by the primary beam of electrons. The magnetic flux generated by an excitation coil 11 is concentrated into a small spatial region around the optical axis OA with the assistance of an upper and a lower pole piece 8, 9. The maximum field strength of the magnetic lens is reached in the pole piece gap 10. The upper electrode 12 of the electrostatic lens includes a cylindrical portion which is arranged in an insulating fashion within a bore in the upper pole piece 8 of the magnetic lens.

The lower pole piece 9 of the magnetic lens preferably lies at ground potential and can be lined with a beam guidance tube of magnetic or non-magnetic material (not shown in Fig. 2) for protection against contamination. The lower pole piece, thus, forms the lower electrode 13 of the electrostatic lens which establishes a retarding field.

A gas conduit 14 is arranged just below the objective lens. The gas conduit is part of a gas supply which further comprises a gas reservoir (not shown in this figure). In the example shown, the gas conduit is provided in form of a tube whose opening for ejecting the gas is directed towards the area of incidence of the primary electron beam. A preferred distance between the lower edge of the outlet opening and the specimen surface is up to 1 mm. In certain applications the distance is about 100 micrometers. In this case, due to the angle of inclination which the tube opening forms with the surface of the specimen, the working distance of the tube opening from the area of the specimen where the beam is incident is about 0,5 mm. Preferably the diameter of the outlet opening is about 100 micrometers. The gas conduit shows a knee portion 17 and the part of the gas conduit which connects the knee portion 17 with the gas reservoir is directed away from the objective lens. However, it is possible to let this pan of the gas conduit run parallel to the lower pole piece of the magnetic lens. Also, it is within the scope of the present invention to use a gas conduit without knee portion. Thereby, it is still desirable to slightly incline the gas conduit with respect to the specimen surface so that the stream of inert gas is directed towards the surface of the specimen.

An exemplary cross section of a scanning electron microscope is shown schematically in Fig. 3. As electron gun 18 a triode gun with a tungsten thermionic filament or, alternatively a brighter emitter such as lanthanum or cerium hexaboride can be used. Another option is e.g. a Schottky field emission gun. A double condenser lens system 19. 20 forms a demagnified image of the 'crossover' of the electron source close after the second condenser lens 20. The objective lens 21 projects the diminished image of the electron crossover as a spot focused on the surface of the specimen. The solid angle of the focused beam is defined by an aperture 23 immediately following the objective lens. The bore of the objective lens 21 also contains the deflection system 22 responsible for scanning the electron probe.

The focused primary electron beam hits the specimen 3 positioned on a specimen holder 27. Both are located in a vacuum chamber 26 connected to vacuum pumps 28 for providing a desired vacuum level so that the primary electrons are not deflected from their predicted path by collisions with any atoms or molecules other than those of the specimen. Furthermore, vacuum pump 29 is provided for evacuating the optical column. The aperture 23 separates the optical column from the specimen chamber 26 to allow for differential pumping. An inert gas in a gas reservoir 25 is guided through a valve 24 to the gas conduit 14 which directs the stream of inert gas onto the specimen 3. In preferred embodiments a nozzle is provided at the end of the gas conduit 14. The valve 24 can be used for adjusting the pressure used for providing the inert gas.

Within the vacuum chamber 26 into which the specimen to be examined is loaded, an exemplary average base pressure of about 5*10E-4 Pa is prevailing. This average base pressure in the chamber increases to about 5*10E-3 Pa if inert gas is directed to the specimen. The pressure at the outlet of the gas conduit is about 10 Pa. The stream of inert gas creates a mini-environment at the point of incidence of the primary electron beam. While significantly reducing the adverse effects of charging close to the surface of the specimen, this mini environment does not substantially affect the average vacuum level in the chamber to an extent where it hinders the transmission of the beam through the optical column. Scattering of the primary electrons with gas molecules in the chamber is thereby kept at an acceptable level. The vacuum gradient is maintained by balancing the gas flow of the inert gas into the specimen chamber with the amount of gas evacuated from that chamber. The pumping port of the vacuum pump is preferrably arranged in alignment with the stream of inert gas.

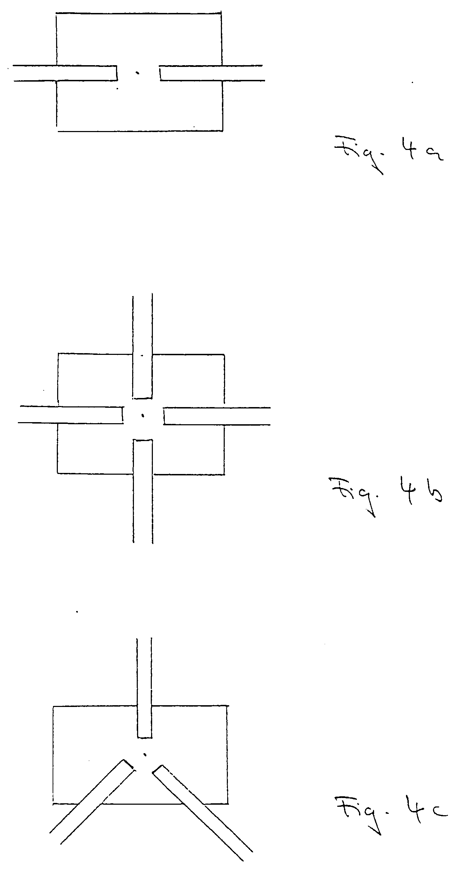

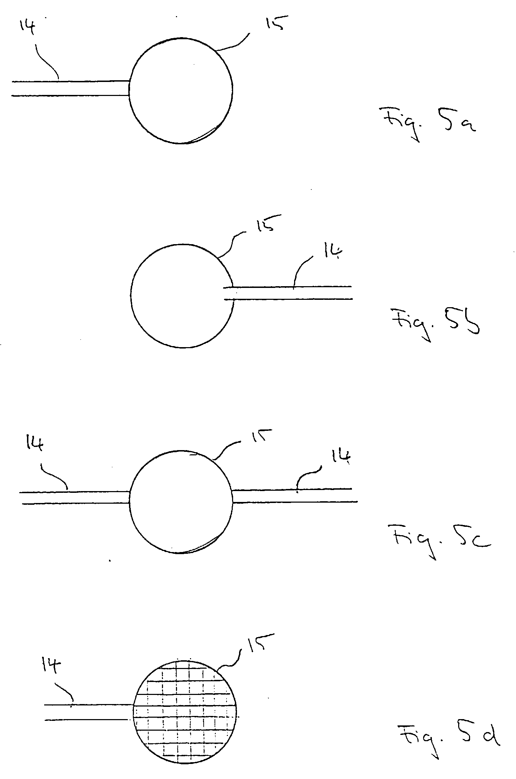

Figs. 4a - 4c show several symmetrical arrangements of gas conduits 14. The location of the incident primary electron beam is the center of symmetry. Figs. 5a - 5d show several exemplary combinations of electrodes 15 and gas conduits 14. In Fig. 5a the electrode is arranged at the tip of the gas outlet or nozzle. In Fig. 5b the gas out let or nozzle projects into the electrode. In Fig. 5 c two gas outlets or nozzles are connected to the reference electrode and in Fig. 5d a conductive net is used to span the rotationally symmetrical electrode. The core mesh of this net is located in the center of the electrode. Alternatively, a rotationally symmetrical conductive net can be used instead of the net shown in Fig. 5d.

The inert gas stream directed to the area of incidence of the charged particle beam onto the specimen significantly reduces the adverse effects of charging without substantially affecting the average vacuum level in the chamber. However, depending on the amount of gas present in the specimen chamber, it may hinder the transmission of the beam before it hits the specimen. In a preferred embodiment of the present invention, this negative effect is reduced by providing a pulsed gas stream which supplies inert gas only in the amount necessary for reducing charging and cuts out excessive inert gas.

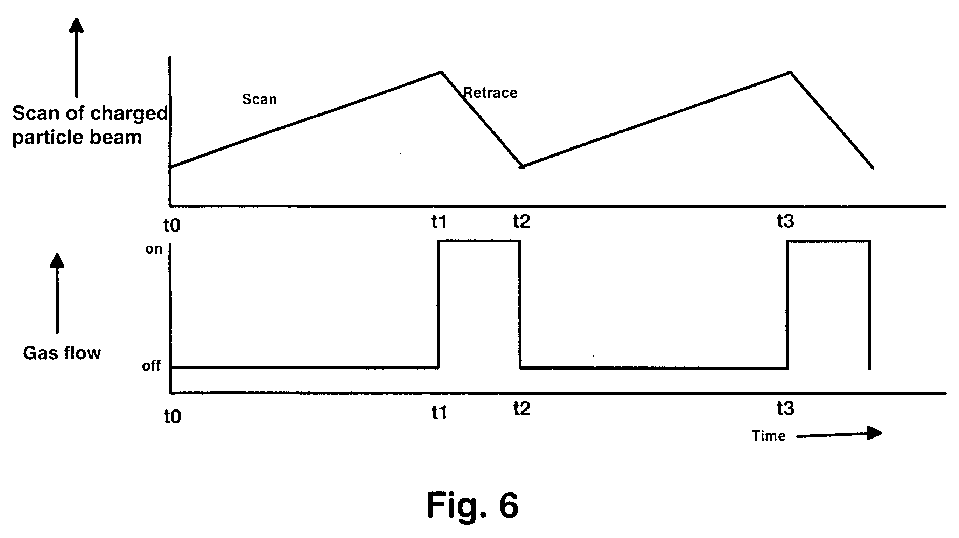

An example of such a pulse mode is shown in Fig. 6. The upper diagram shows the scanning movement of the charged particle beam. Similar to the scanning of an electron beam on a television screen, the charged particle beam is guided in a first movement across a first line in the area of the specimen to be examined. The scan movement takes place in the time interval 0 to t1. An image of this line is created by the detection of secondary particles created by the impinging primary particles. At the end of this line, the charged particle beam is retraced to just below the beginning of the line. The retrace movement takes place in the time interval t1 to t2 and during this time interval no image of the specimen is created. Subsequently, the charged particle beam is guided within the time interval t2 to t3 in a second scan movement across the area of the specimen to be examined creating a second line of the respective image. The lower diagram shows the time correlation between the flow of inert gas and the scanning movement of the charged particle beam. In this specific example, the stream of inert gas is directed to the area of incidence during the retrace movement of the charged particle beam i.e. within the time interval t1 to t2. No inert gas is directed to the specimen during the scan movement. This avoids collisions between the primary particles and gas particles. The inert gas particles which are directed to the specimen during the retrace movement remain for some time close to the surface of the specimen thereby reducing the adverse effects of charging. In certain applications, it will not be necessary to provide the inert gas during the complete retrace movement. It can be of advantage to stop the gas stream prior to t2 if inert gas has been provided in a sufficient amount so that it is still capable to reduce charging for the next scanning movement. Alternatively, it can be advantageous to still provide inert gas during the first part of the scanning movement so that there are still enough gas particles present and close to the area of incidence to prevent charging at the end of the scanning interval.

Depending on the length of the gas conduit, the pressures used for providing the inert gas, and the distances between the end opening of the gas conduit and the area of incidence, the inert gas particles require some time before they reach the area of incidence. This time delay is considered in an alternative embodiment of the invention, where the on-phase of the pulsed gas stream is initiated prior to t1 and the gas stream is switched off prior to t2. The two time shifts prior to t1 and t2 do not necessarily have to have the same length of time.

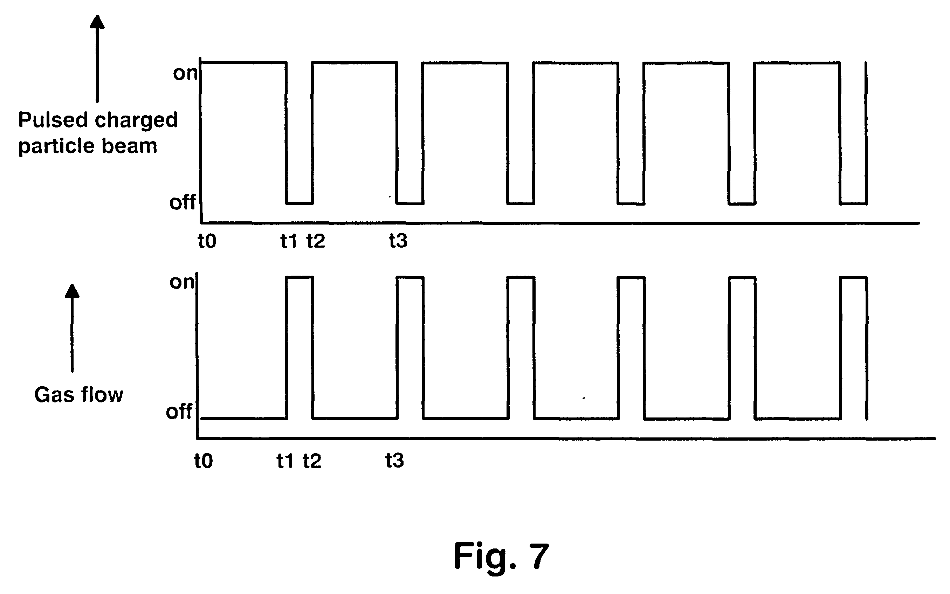

A different correlation between the control of the charged particle beam and the pulsed gas stream is shown in Fig. 7. The upper part of the diagram shows a pulsed charged particle beam during the scanning movement. At t1 the charged particle beam is switched off and at t2 it is switched on again. At t2 the scanning movement of the charged particle beam is continued at the same spot of the specimen where the scanning movement was interrupted at t1. The lower part of the diagram shows that the scanning pause is used to direct a stream of inert gas onto the area of incidence. Since there are no charged particles impinging on the specimen during the time interval t1 to t2, the number of collisions between primary and secondary particles on one side and gas particles on the other side is considerably reduced. As explained with respect to Fig. 6, the time interval during which inert gas is provided to the area of incidence can be time shifted with respect to the pulse pauses of the charged particle beam. Also, the time intervals during which inert gas is provided can be longer or shorter than the pulse pauses of the charged particle beam.

It is important to note that all of the above described pulse modes are only examples of a vast variety of pulse modes which are capable of reducing charging by providing inert gas to the area of incidence and, simultaneously, trying to keep the disturbing effects of the gas particles which collide with primary and secondary particles to a minimum. All of these pulse variations are within the scope of the present invention.

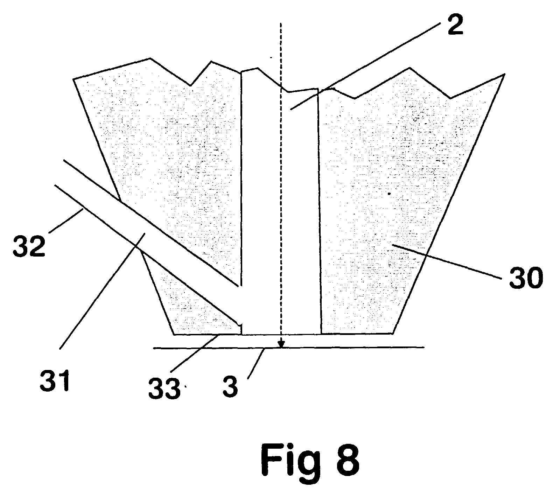

Parts made out of conductive or magnetic material which are arranged in the vicinity of electrical and magnetic fields influence these fields. To avoid disturbing effects an electrode creating an electrostatic field with a rotational symmetry was used to limit the influence on the trajectory of the incident charged particle beam and the secondary particles. A nozzle or gas conduit, which are made out of conductive or magnetic material, directing the inert gas to the specimen could influence the fields of e.g. the objective lens. In a preferred embodiment shown in Fig. 8, the gas conduit 32 is integrated into the objective lens. A drilling 31 in the pole piece 30 of the magnetic lens can either serve directly as a gas conduit or acts as an enclosure for a nozzle or tube implemented into the drilling 31. The opening of the drilling as shown in Fig. 8 ends at the inner cylinder of the pole piece 30. Alternatively, the open end of the drilling can be arranged in the lower end of the pole piece facing the specimen.

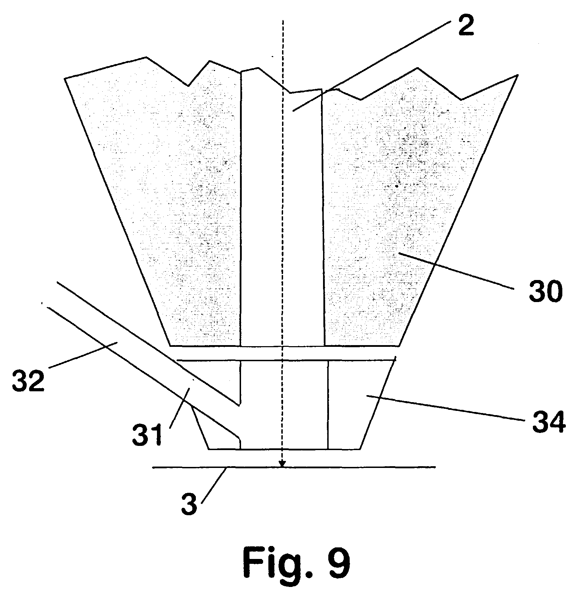

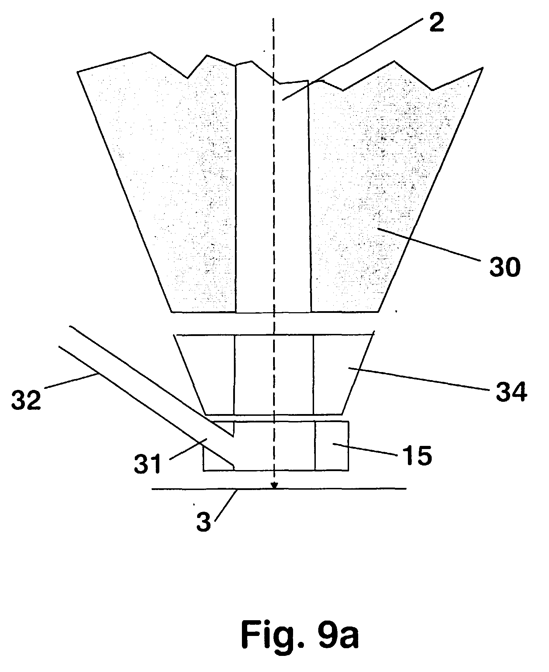

Fig. 9 shows the electrode of an electrostatic lens 34 arranged between the pole piece 30 of a magnetic lens and the specimen 3. Here, the gas conduit 31 is integrated into the electrode. A drilling 31 serves directly as gas conduit or acts as enclosure for a nozzle or a tube. Fig. 9a shows the same arrangement as Fig. 9, whereby an additional reference electrode 15 is placed between the electrode of the electrostatic lens 34 and the specimen 3. This reference electrode could also be placed between the specimen and the pole piece of the embodiment shown in Fig. 8. By integrating the gas conduit into mechanical parts arranged in the direct vicinity of or closest to the specimen the set up of the microscope column does not have to be changed and the electric and magnetic fields for directing the primary and secondary particles are hardly altered. The integration of a gas conduit into mechanical parts in the vicinity of and/or closest to the area of impact of the charged particle beam is preferably used in combination with the above described charging phenomenon, however, it can also be used in all kinds of charged particle beam apparatuses where a gas interacts with a charged particle beam.

The gas flow which is directed to the specimen can be controlled with a continuously adaptable valve for the flow control. Alternatively, it is possible to use a pulsed gas stream with a pulse frequency sufficiently high so that the pulsating gas flow provides a consistent gas layer or environment close to the area of incidence. A fine tuning of the gas environment can be achieved by choosing a proper on/off ratio for the pulse mode.

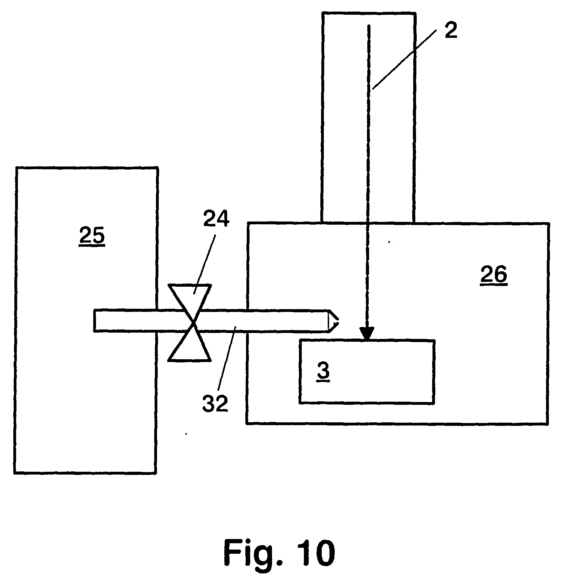

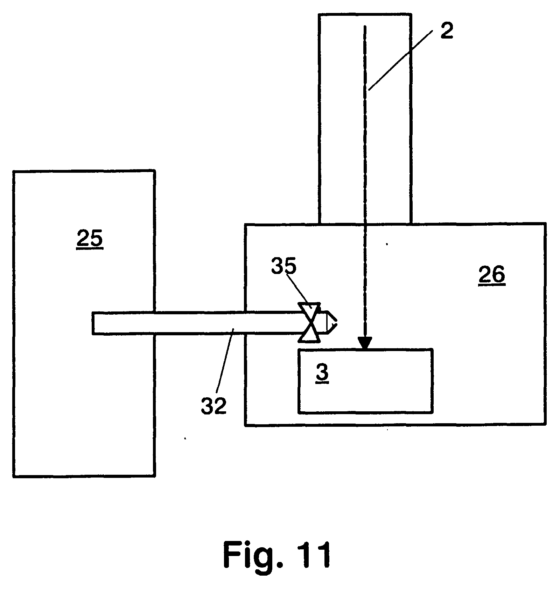

Fig. 10 shows an embodiment in which the valve 24 for manipulating the stream of gas is situated in between the specimen chamber 26 and the gas reservoir 25. By opening and closing the valve a pulsed gas stream is created and directed through the gas conduit 32 to the specimen 3. Fig. 11 shows an alternative embodiment in which a micro valve 35 is integrated close to the end of the gas conduit. This has the advantage that after the closing of the micro valve 35, the time required to evacuate the remaining gas in the gas conduit is considerably reduced.

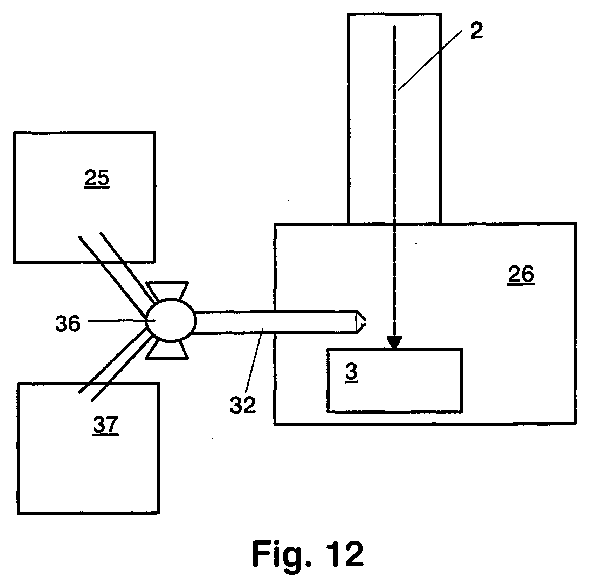

In a further embodiment shown in Fig. 12 a 2 way valve 36 is used. One port of the 2 way valve 36 is connected to the gas reservoir 25 and the other port of the 2 way valve is connected to a vacuum reservoir. Preferably, the volume of the vacuum or evacuated reservoir is much bigger than the volume of the gas conduit 32. In order to shut off the gas flow, the connection between the gas conduit 32 and the gas reservoir 25 is interrupted and the connection between the gas conduit 32 and the evacuated reservoir 36 is opened. This results in an immediate drop in pressure in the gas conduit. This arrangement can be more advantageous than use of a micro valve. The 2 way valve can not only be used to reduce charging by providing inert gas, but it can be applied in all charged particle apparatuses in which a gas flow of any kind is directed to the area of incidence of a charged particle beam. This allows the gas or gases to interact with the corpuscular beam in defined time intervals. Instead of a 2-way valve a multiple way valve could be used and more than one port connected with different gas reservoirs and/or more than one port could be connected with different vacuum reservoir. Advantageously a gas conduit integrated into mechanical parts of the charged particle beam apparatuses e.g. as shown in Figs. 8, 9 and 9a is used.

## Claims

1. An apparatus for examining a specimen with a beam of charged particles comprising:
a particle source for providing a beam of charged particles;
an optical device for directing said beam of charged particles onto said specimen to be examined;
a gas supply for providing an inert gas to the area of incidence of said beam of charged particles onto said specimen; and
a vacuum chamber for loading said specimen.

2. The apparatus according to claim 1 wherein the inert gas forms a layer covering the area of incidence of said beam of charged particles.

3. The apparatus according to claim 2 wherein the layer of inert gas in the area of incidence of said beam of charged particles has a thickness of less than about the mean free path of the charged particles.

4. The apparatus according to any of the preceding claims wherein the gas supply further comprises at least one nozzle for directing a stream of inert gas to the area of incidence of said beam of charged particles for providing said inert gas.

5. The apparatus according to claim 4 further comprising means for adjusting the position of said nozzle or nozzles.

6. The apparatus according to any of claims 4 to 5 wherein at least two nozzles for directing the stream of inert gas are arranged in a symmetrical pattern around the area of incidence of said beam of charged particles onto the specimen.

7. The apparatus according to any of the preceding claims further comprising means for adjusting in said gas supply the pressure used for providing the inert gas.

8. The apparatus according to any of the preceding claims further comprising an electrode arranged in the vicinity of the area of incidence of said beam of charged particles for controlling charging of the specimen to a desired voltage.

9. The apparatus according to claim 8 further comprising means for positioning said electrode.

10. The apparatus according to any of claims 8 to 9 wherein said electrode and said nozzle are connected with each other.

11. The apparatus according to any of claims 8 to 10 wherein said electrode comprises a circular ring electrode.

12. The apparatus according to any of claims 8 to 11 wherein said electrode further comprises a conductive net with at least one opening for said beam of charged particles.

13. The apparatus according to any of the preceding claims further comprising vacuum means capable of providing within said vacuum chamber a pressure gradient between the area of incidence of said beam of charged particles and the aperture in said vacuum chamber for said beam of charged particles.

14. The apparatus according to claim 13 wherein said pressure gradient can be kept at a pressure of about 1-100 Pa at the area of incidence of said beam of charged particles and at a pressure of less than about 10P(-2) Pa at the aperture in said vacuum chamber for said beam of charged particles.

15. The apparatus according to any of the preceding claims wherein the gas supply further comprises at least one gas tank.

16. The apparatus according to any of the proceeding claims wherein the gas supply comprises means for providing the gas in a pulsating manner.

17. The apparatus according to any of the preceding claims wherein the gas supply comprises a gas conduit for directing a stream of inert gas onto the area of the specimen to be examined.

18. The apparatus according to claim 17 wherein the gas conduit is integrated into mechanical parts in the vicinity of and/or closest to the specimen to be examined.

19. The apparatus according to any one of the preceding claims further comprising a micro valve arranged in the vicinity of the outlet opening for the inert gas of the gas supply.

20. The apparatus according to any one of claims 1 to 18 further comprising a 2-way valve arranged in the gas supply whereby a first port of the 2-way valve is connected to a gas reservoir and a second port of the 2-way valve is connected to a vacuum reservoir.

21. A charged particle beam apparatus comprising:
a particle source for providing a beam of charged particles;
an optical device for directing said beam of charged particles onto said specimen to be examined;
a gas supply for providing a gas to the area of incidence of said beam of charged particles;
a 2-way valve arranged in the gas supply whereby a first port of the 2-way valve is connected with a gas reservoir and a second port of the gas supply is connected with a vacuum reservoir; and
a control unit for switching the 2-way valve.

22. A charged particle beam according to claim 21 whereby the gas supply further comprises a gas conduit for providing the gas to the area of incidence of said beam of charged particles.

23. A charged particle beam according to claim 22 whereby the gas conduit is integrated into mechanical parts in the vicinity of and/or closest to the area of incidence of said beam of charged particles.

24. A method for examining a specimen using a charged particle beam comprising the following steps:
a. loading said specimen in a vacuum chamber;
b. directing said charged particle beam to a desired position of said specimen to be examined; and
c. providing a stream of inert gas to said desired position.

25. The method according to claim 16 wherein step c is performed to provide a layer of inert gas over said desired position.

26. The method according to any of claims 16 to 17 further comprising the step of d. providing a reference electrode in the vicinity of said desired position.

27. The method according to claim 18 wherein step d. is performed by a circular electrode.

28. The method according to any one of claims 24 to 27 wherein step c is performed in a pulsating manner.
